(19) Europäisches Patentamt
European Patent Office
Office européen des brevets

(11) Veröffentlichungsnummer: **0 063 716**
**A2**

# (12) EUROPÄISCHE PATENTANMELDUNG

(21) Anmeldenummer: **82102847.9**

(22) Anmeldetag: **03.04.82**

(51) Int. Cl.³: **C 23 C 11/06**, H 01 L 31/18

(30) Priorität: **29.04.81 DE 3117070**

(43) Veröffentlichungstag der Anmeldung: **03.11.82**
**Patentblatt 82/44**

(84) Benannte Vertragsstaaten: **FR GB IT NL**

(71) Anmelder: **Licentia Patent-Verwaltungs-GmbH,**
**Theodor-Stern-Kai 1, D-6000 Frankfurt/Main 70 (DE)**

(72) Erfinder: **Dahlberg, Reinhard, Dr., Innere Bergstrasse 32,**
**D-7101 Flein (DE)**

(74) Vertreter: **Langer, Karl-Heinz, Dipl.-Ing., Licentia**
**Patent-Verwaltungs-GmbH Theodor-Stern-Kai 1,**
**D-6000 Frankfurt/Main 70 (DE)**

## (54) Verfahren zum Herstellen einer Halbleiter-Schicht-Solarzelle.

(57) Bei einem Verfahren zum Herstellen einer Halbleiter-Schicht-Solarzelle, bei dem das Halbleitermaterial mit Hilfe von Plasma-Spritzen auf einen Träger aufgebracht wird, wird die Energiedichte in der Plasma-Zone so groß gewählt, daß das Halbleitermaterial verdampft. Das Halbleitermaterial wird als Dampf-Strahl aus der Plasma-Zone herausgeführt und auf einem Träger in Form einer Halbleiterschicht niedergeschlagen.

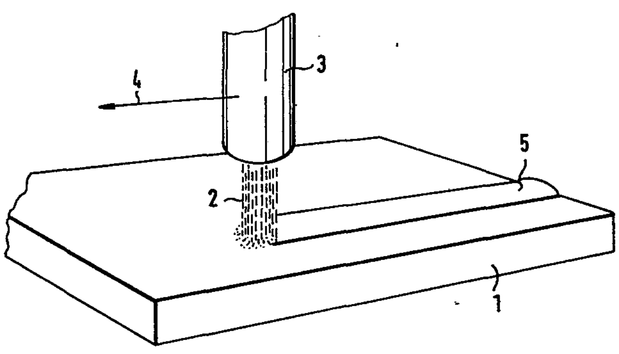


EP 0 063 716 A2

Licentia Patent-Verwaltungs-G.m.b.H.
Theodor-Stern-Kai 1, 6000 Frankfurt 70

0063716

Heilbronn, den 21.04.81
Z13-HN-La-et - HN 81/20

# Verfahren zum Herstellen einer Halbleiter-Schicht-Solarzelle

Zur Nutzung der Sonnenenergie auf der Erde sind Solarzellen aus einkristallinen Halbleiterscheiben nur für Spezialanwendungen einsetzbar. Ihre Herstellkosten und der für ihre Herstellung aufzuwendende Energieverbrauch sind so hoch, daß der Einsatz von einkristallinen Zellen heute nur zusammen mit Konzentratoren für das Sonnenlicht sinnvoll erscheint. Dabei muß dann aber noch für eine ausreichende Kühlung der Solarzellen gesorgt werden.

Wesentlich kostengünstigere Solarzellen lassen sich mit amorphen oder polykristallinen Halbleiterschichten herstellen. Amorphe Silizium-Schichten z. B. lassen sich durch Aufdampfen im Vakuum oder durch Kathoden-Zerstäubung oder Hochfrequenz-Zerstäubung von Silizium in einer Wasserstoff-haltigen Atmosphäre erzeugen. Während Solarzellen aus amorphem Silizium noch den Nachteil haben, daß ihr Wirkungsgrad nur wenige Prozent beträgt, lassen sich Solarzellen aus polykristallinem Silizium mit Wirkungsgraden von 10 % herstellen. Besonders gute Wirkungsgrade ergibt ein polykristallines Silizium-Material, bei welchem die Kristallite eine Vorzugsrichtung aufweisen. Das polykristalline Silizium für die Solarzellen-Herstellung wird beispielsweise dadurch hergestellt, daß flüssiges Silizium in die Form eines Barrens mit quadratischem Querschnitt gegossen wird. Die Erstarrung des flüssigen Siliziums im Barren erfolgt in einem Temperaturgradienten. Der erstarrte Barren wird nach dem Erkalten in Scheiben zersägt, aus welchen die Solarzellen gefertigt werden. Das flüssige

Silizium kann aber auch direkt in Form einer Platte gegossen werden. Dabei entfällt die Notwendigkeit des Zersägens.

Es ist auch bekannt, einen geeigneten Träger, z. B. Graphit, in eine Silizium-Schmelze zu tauchen, so daß der Träger nach dem Herausziehen aus der Schmelze mit einer dünnen Silizium-Schicht überzogen ist. Diese Silizium-Schicht auf dem Träger kann dann wieder zu einer Solarzelle verarbeitet werden. Auf ähnliche Weise läßt sich auch ein Träger mit einer Schicht aus einer III/V-Verbindung (z. B. mit einer dünnen Schicht aus GaAs) versehen, welche zu einer Solarzelle weiterverarbeitet werden kann.

Der Erfindung liegt die Aufgabe zugrunde, die Herstellkosten und den Energieverbrauch bei der Herstellung einer Halbleiter-Schicht-Solarzelle weiter zu reduzieren. Diese Aufgabe wird bei einem Verfahren zum Herstellen einer Halbleiter-Schicht-Solarzelle, bei dem das Halbleitermaterial mit Hilfe von Plasma-Spritzen auf einen Träger aufgebracht wird, erfindungsgemäß dadurch gelöst, daß die Energiedichte in der Plasma-Zone so groß gewählt wird, daß das Halbleitermaterial verdampft, und daß das Halbleitermaterial als Dampf-Strahl aus der Plasma-Zone herausgeführt und auf einem Träger in Form einer Halbleiterschicht niedergeschlagen wird.

Das Halbleitermaterial kann als Stab oder aber auch als Pulver vorliegen. In beiden Fällen wird das Halbleitermaterial im Lichtbogen oder im Plasma verdampft und in Form eines Dampf-Strahls aus Halbleitermaterial auf dem Träger abgeschieden.

Im Falle des Halbleitermaterials Silizium kann man z. B. nach einer der Reaktionen:

$$3\ K_2SiF_6 + 4\ Al = 3\ Si + 2\ KAlF_4 + 2\ K_2AlF_5$$

oder $SiO_2 + 2\ Mg = Si + 2\ M_gO$

oder $NaSiF_6 + 2\ Na = Si + 3\ NaF_2$

das Silizium herstellen.

Durch Pulverisieren und Behandeln mit HCl läßt sich das Silizium-Pulver von metallischem Al, Mg bzw. Na befreien. Das so gewonnene Silizium-Pulver kann durch Lichtbogen-Spritzen oder Plasma-Spritzen gemäß der Erfindung direkt auf einen Träger aufgebracht werden.

Der Träger kann aus elektrisch leitendem Material, wie z. B. aus Aluminium oder Stahl, bestehen. Der Träger bildet dann gleichzeitig auch den elektrischen Rückseiten-Kontakt der Solarzelle.

Der Träger kann aber auch aus einem isolierenden Material, wie z. B. Glas, Porzelan, Keramik, Kunststoff usw. bestehen. In diesem Falle ist der Träger wenigstens teilweise mit einer elektrisch leitenden Schicht aus z. B. Metall oder einem Carbid, Borid oder Nitrid überzogen.

Als Halbleiter-Materialien können erfindungsgemäß n- oder p-leitende Element-Halbleiter, wie z. B. Silizium, Germanium, Kohle, Bor u. a. oder III/V-Halbleiter, wie z. B. AlSb, GaAs, InP u. a. oder auch II/VI-Halbleiter, wie z. B. CdTe, CdS u. a. verwendet werden.

Das erfindungsgemäße Aufbringen des Halbleiter-Materials auf den Träger geschieht vorzugsweise im Vakuum oder in einer Sauerstoffreien Edelgas-, Wasserstoff- oder Stickstoff-Atmosphäre.

Die Atmosphäre kann jedoch auch Gase enthalten, wie z. B. HCl, Hf, $Cl_2$, $J_2$, $S_2$ u. a., welche mit dem Halbleiterdampf nicht oder nur wenig, mit den Verunreinigungen im Halbleiterdampf jedoch stark reagieren. Dadurch kann während des Lichtbogen- oder Plasma-Spritzens eine Nachreinigung des Halbleitermaterials erzielt werden.

Zur Beeinflussung der Haftfestigkeit, zur Erzeugung einer Reaktion mit dem Trägermaterial oder zur Erzielung einer bestimmten mittleren Kristallit-Größe des Halbleitermaterials kann es vorteilhaft sein, die Temperatur des Trägers zu erhöhen. Der Träger hat vorzugsweise eine Temperatur > 200 °C während des Aufbringens der Halbleiterschicht. Unter Verwendung einer Maske läßt sich die Halbleiterschicht auch als flächenhafte Struktur auf den Träger aufbringen.

Wegen der hohen Lichtbogen- oder Plasma-Temperaturen lassen sich Halbleiter-Schichten aus einem Verbindungshalbleiter, wie z. B. AlSb, auch dadurch aufbringen, daß man ein geeignetes Pulvergemisch der Verbindungspartner, wie z. B. Aluminiumpulver + Antimonpulver, auf den Träger aufspritzt. Die Verbindungsbildung erfolgt dann im Lichtbogen- oder Plasma-Strahl.

Nach dem Aufbringen der Halbleiterschicht auf den Träger kann der Träger mit der Halbleiterschicht (z. B. zur Verbesserung der Halbleitereigenschaften der Schicht) getempert werden.

Die Halbleiterschicht kann nach dem Aufbringen auf den Träger aber auch mit einem Lichtbogen-Strahl oder Plasma-Strahl sehr kurzzeitig von einer Seite aufgeheizt oder aufgeschmolzen werden.

Auch mit Hilfe eines fokussierten Licht- oder LASER-Strahls kann die Halbleiter-Schicht kurzzeitig aufgeheizt oder aufgeschmolzen werden.

Gemäß einer Ausführungsform der Erfindung weist die Solarzelle auf der freien Seite der Halbleiter-Schicht einen oberflächennahen p-n-Übergang auf. Dieser p-n-Übergang wird beispielsweise in an sich bekannter Weise mit Hilfe von Diffusion, Ionenimplantation oder Epitaxie hergestellt.

Gemäß einer anderen Ausführungsform der Erfindung ist die freie Seite der Halbleiter-Schicht mit einem lichtdurchlässigen Schottky-Kontakt versehen. Dieser Schottky-Kontakt

kann in an sich bekannter Weise z. B. durch Aufdampfen, Aufsputtern, Aufspritzen oder chemisches Abscheiden einer metallisch leitenden Schicht erzeugt werden.

Es besteht auch die Möglichkeit, daß die freie Seite der Halbleiter-Schicht nach der Erfindung einen lichtdurchlässigen Hetero-Übergang aufweist. Dieser Hetero-Übergang kann z. B. durch Aufbringen einer lichtdurchlässigen Halbleiter-Schicht aus $SnO_2$, $In_2O_3$, $WO_2$, $V_2O_3$, $Ti_2O_3$, $Cu_2O$, $Cu_2S$, $Nb_2O_3$, GeTe u. a. hergestellt werden.

Da Metall-Isolator-Halbleiter-Kontakte (MIS-Kontakte) und Halbleiter-Isolator-Halbleiterkontakte (SIS-Kontakte) besonders große Wirkungsgrade ergeben, empfiehlt es sich, die Halbleiterschicht mit einer Isolatorschicht zu überziehen, deren Dicke kleiner als $1 \cdot 10^{-6}$ cm - vorzugsweise $2 \cdot 10^{-7}$ cm ist. Die Metallschicht für den Schottky-Kontakt bzw. die Halbleiterschicht für den Hetero-Übergang befinden sich dann auf dieser dünnen Isolatorschicht.

Der Schottky-Kontakt oder der Hetero-Übergang an der Halbleiterschicht können erfindungsgemäß auch als mechanischer Druck-Kontakt zwischen der Halbleiter-Schicht und einem lichtdurchlässigen Formkörper ausgebildet sein. Dabei ist der Formkörper mindestens am Druck-Kontakt mit einer lichtdurchlässigen Metall-Schicht oder mit einer lichtdurchlässigen Halbleiter-Schicht überzogen.

<u>Ausführungsbeispiel 1</u> beschreibt im Prinzip das Aufbringen einer Halbleiterschicht auf einen Träger mit Hilfe von Lichtbogen-Spritzen.

<u>Ausführungsbeispiel 2</u> beschreibt im Prinzip das Aufbringen einer Halbleiterschicht als flächenhafte Struktur auf einen Träger mit Hilfe des Plasma-Spritzens gemäß der Erfindung in einer Sauerstoff-freien und Phosphin-haltigen Atmosphäre.

Ausführungsbeispiel 3 gibt im Querschnitt den Aufbau einer Halbleiter-Schicht-Solarzelle auf einem Metall-Träger mit einer p-Silizium-Schicht und einem p-n-Übergang wieder.

Ausführungsbeispiel 4 zeigt im Querschnitt den Aufbau einer Halbleiter-Schicht-Solarzelle auf einem metallisierten Isolator-Träger mit n-Silizium-Schicht und MIS-Kontakt.

Ausführungsbeispiel 5 zeigt eine Halbleiter-Schicht-Solarzelle auf einem metallisierten Isolator-Träger mit einer p-Silizium-Schicht und SIS-Druck-Kontakten zwischen der Halbleiterschicht und einem lichtdurchlässigen Formkörper.

Ausführungsbeispiel 1

In Fig. 1 ist 1 ein Träger aus Aluminium. Duch einen Lichtbogen zwischen zwei p-leitenden Silizium-Stäben wird aus einer Düse 3 Stickstoff geblasen. Das Silizium schmilzt und verdampft im Lichtbogen und wird durch den im Lichtbogen aufgeheizten Stickstoff-Strahl 2 auf den Träger 1 aufgebracht. Dort kondensiert der Siliziumdampf zu einer p-leitenden polykristallinen Silizium-Schicht 5.
Die Düse 3 mit dem Lichtbogen-Strahl 2 führt eine seitliche Bewegung 4 aus. Dadurch wird eine gleichmäßig dicke Silizium-Schicht 5 auf dem Träger 1 erzeugt.

Ausführungsbeispiel 2

In Fig. 2 ist 1 ein Träger aus Glas, welcher auf seiner Oberseite eine Aluminiumschicht 6 trägt. Durch die Maske 7 wird mit Hilfe des Argon-Strahls 2 aus der Düse 3 durch einen Lichtbogen hindurch, welcher zwischen gekühlten Wolfram-Elektroden brennt, n-leitendes Silizium-Pulver geblasen. Die den Plasma-Strahl 2 umgebende Atmosphäre 8 enthält Phosphin-Gas. Die im Plasma-Strahl 2 verdampften Silizium-Teilchen treffen als Dampf-Strahl auf die Aluminium-Schicht 6, welcher zu einer zusammenhängenden n-Silizium-Schicht 5 kondensiert. Der Träger 1 aus Glas führt bei diesem Prozeß eine seitliche Bewegung 4 aus.

Ausführungsbeispiel 3

In Fig. 3 ist 1 ein Träger aus einer Aluminium-Legierung. 5 ist eine mit dem Plasma-Strahl gemäß der Erfindung erzeugte polykristalline Silizium-Schicht mit einer Dicke von 4 . $10^2$ cm und einem ohmschen Widerstand von 0,1 Ωcm. Durch Implantation von Phosphor-Ionen in die freie Oberfläche der Silizium-Schicht 5 wird die oberflächen-nahe $n^+$-Schicht 9 erzeugt. 10 ist ein kammförmiger Aluminium-Kontakt für die Vorderseite. Durch die Sonnen-Bestrahlung 11 entsteht zwischen dem Vorderseiten-Kontakt 10 und dem Träger 1 aus Aluminium eine Fotospannung.

Ausführungsbeispiel 4

In Fig. 4 ist 1 ein Träger aus Porzellan, der auf seiner Oberseite mit einer 5 . $10^{-3}$ cm dicken Schicht 6 aus TiO überzogen ist. Auf diese TiO-Schicht 6 ist die n-Silizium-Schicht 5 mit Hilfe eines Plasma-Strahls gemäß der Erfindung aufgebracht. Die n-Silizium-Schicht 5 ist 1,5 . $10^{-2}$ cm dick und hat einen spezifischen Widerstand von 1 . $10^{-2}$ cm. Sie wird nach ihrem Aufbringen mit Hilfe eines LASER-Strahles sehr kurzzeitig an ihrer Oberfläche aufgeschmolzen. Die aufgeschmolzene Oberfläche ist mit einer $SiO_2$-Schicht 12 mit einer Dicke von 2 . $10^{-7}$ cm überzogen. Auf diese $SiO_2$-Schicht 12 ist im Vakuum eine 2 . $10^{-6}$ cm dicke Nickel-Schicht 13 aufgedampft, wodurch eine MIS-Struktur entsteht. 10 ist eine kammförmige Kupferschicht, welche der Vorderseiten-Kontakt der Solarzelle ist. Bei Sonneneinstrahlung 11 liegt zwischen der TiO-Schicht 6 und der Kupferschicht 10 die Fotospannung der Solarzelle.

Ausführungsbeispiel 5

In Fig. 5 ist 1 ein Glasträger mit den Abmessungen 25 x 25 x 0,3 $cm^3$. Auf den Glasträger 1 ist eine Aluminium-Schicht 6 von 1 . $10^{-2}$ cm Dicke aufgebracht. Auf die Aluminium-Schicht 6 wird mit Hilfe eines Plasma-Strahls gemäß der Erfindung eine

p-Silizium-Schicht 5 mit einer Dicke von $2 \cdot 10^{-2}$ cm aufgebracht. Die freie Oberfläche der Silizium-Schicht ist von der $SiO_2$-Schicht 12 bedeckt, die eine Dicke von $2 \cdot 10^{-7}$ cm hat. Der lichtdurchlässige Formkörper 16 ist ebenfalls eine Glasplatte mit den Abmessungen 25 x 25 x 0,3 $cm^3$. Auf ihrer Unterseite trägt die Glasplatte 16 Paraboloid-förmige Erhebungen 17, welche aus quadratischen Grundflächen mit einer Größe von je 0,5 x 0,5 $mm^2$ herauswachsen. Diese quadratischen Grundflächen ergeben eine zusammenhängende Fläche von 24 x 24 $cm^2$. In ihrer Brennebene 18 sind die Paraboloid-förmigen Erhebungen 17 abgeschnitten. Auf die gesamte Oberfläche der Paraboloid-förmigen Erhebungen 17 ist eine $2 \cdot 10^{-5}$ cm dicke Schicht 14 aus 90 $SnO_2$ + 10 $In_2O_3$ aufgebracht. Danach ist eine $5 \cdot 10^{-3}$ cm dicke Aluminium-Schicht 10 auf die Oberfläche der Paraboloid-förmigen 17 - mit Ausnahme ihrer Abschnittsflächen 18 - aufgebracht. Die Glasplatte 16 ist danach mit den Paraboloid-förmigen Erhebungen 17 so auf die Silizium-Schicht 5 aufgesetzt, daß die mit der Schicht 14 überzogenen Abschnittsflächen 18 auf der $SiO_2$-Schicht 12 der Silizium-Schicht 5 aufliegen. Die Ränder der beiden Glasplatten 1 und 16 werden im Vakuum 20 mit Hilfe des Glaslotes 19 so verschmolzen, daß der atmosphärische Außendruck zwischen den Paraboloid-förmigen Erhebungen 17 und der Halbleiterschicht ca. 230 000 elektrisch parallele SIS-Druck-Kontakte erzeugt. Das Sonnenlicht 11 wird durch die Paraboloid-förmigen Erhebungen 17 in deren Abschnittsflächen 18 so konzentriert, daß es mit ca. 5facher Intensität der Sonnen-Strahlung 11 durch die SIS-Kontakte 21 in die Halbleiterschicht 5 eindringt. Wegen der extrem guten Wärmeableitung in den punktförmigen Druckkontakten 21 kommt es zu keiner merklichen Übertemperatur in den Kontakten 21. Die Fotospannung der Solarzelle liegt zwischen den Aluminium-Schichten 6 und 10.

Erwähnt sei noch, daß der Paraboloid-förmigen Ausbildung der Erhebungen bei der Bildung von Druckkontakten allgemeine, nicht auf die Erfindung beschränkte Bedeutung zukommt.

0063716

Licentia Patent-Verwaltungs-G.m.b.H.
Theodor-Stern-Kai 1, 6000 Frankfurt 70

Heilbronn, den 21.04.81
Z13-HN-La-et - HN 81/20

## Patentansprüche

1) Verfahren zum Herstellen einer Halbleiter-Schicht-Solarzelle, bei dem das Halbleitermaterial mit Hilfe von Plasma-Spritzen auf einen Träger aufgebracht wird, dadurch gekennzeichnet, daß die Energiedichte in der Plasma-Zone so groß gewählt wird, daß das Halbleitermaterial verdampft, und daß das Halbleitermaterial als Dampf-Strahl aus der Plasma-Zone herausgeführt und auf einem Träger in Form einer Halbleiterschicht niedergeschlagen wird.

2) Verfahren nach Anspruch 1, dadurch gekennzeichnet, daß das Substrat, auf dem der Halbleiter-Dampf-Strahl in Form einer Schicht niedergeschlagen wird, sich im Vakuum befindet.

3) Verfahren nach einem der vorhergehenden Ansprüche, dadurch gekennzeichnet, daß eine oder beide Elektroden der Plasma-Spritzanlage aus Halbleitermaterial bestehen.

4) Verfahren nach einem der vorhergehenden Ansprüche, dadurch gekennzeichnet, daß das Halbleitermaterial in Form eines Pulvers in die Plasma-Zone eingebracht wird.

5) Verfahren nach einem der vorhergehenden Ansprüche, dadurch gekennzeichnet, daß das Halbleitermaterial in Form eines Stabes in die Plasma-Zone hineinreicht, und daß das Ende des Halbleiterstabes in der Plasma-Zone schmilzt und verdampft.

6) Verfahren nach einem der vorhergehenden Ansprüche, dadurch gekennzeichnet, daß die Elektroden der Plasma-Spritz-Anlage aus Halbleitermaterial bestehen und daß das Elektrodenmaterial im Plasma verdampft und auf dem Substrat abgeschieden wird.

7) Verfahren nach einem der vorhergehenden Ansprüche, dadurch gekennzeichnet, daß als Trägergas des Plasmas Wasserstoff, Stickstoff oder Edelgas, oder ein Gemisch aus diesen Gasen verwendet wird.

8) Verfahren nach einem der vorhergehenden Ansprüche, dadurch gekennzeichnet, daß das Plasma der Plasma-Spritzanlage nur im Dampf des Halbleitermaterials brennt.

9) Verfahren nach einem der vorhergehenden Ansprüche, dadurch gekennzeichnet, daß eine Wasser-stabiliserte-Plasma-Spritz-Anlage benützt wird, und daß das Plasma in dissoziiertem Wasserdampf mit Wasserstoff-Überschuß brennt.

10) Verfahren nach einem der vorhergehenden Ansprüche dadurch gekennzeichnet, daß das Halbleitermaterial auf einen Träger aus elektrisch leitendem Material aufgebracht wird.

11) Verfahren nach einem der vorhergehenden Ansprüche, dadurch gekennzeichnet, daß das Halbleitermaterial auf einen Träger aus elektrisch isolierendem Material aufgebracht wird, welcher wenigstens teilweise mit einer elektrisch leitenden Schicht überzogen ist.

12) Verfahren nach einem der vorhergehenden Ansprüche, dadurch gekennzeichnet, daß als Halbleitermaterial n- oder p-leitendes Silizium, Germanium, Kohlenstoff, Bor, eine III/V-Verbindung oder eine II/VI-Verbindung verwendet wird.

13) Verfahren nach einem der vorhergehenden Ansprüche, dadurch gekennzeichnet, daß auf einer Seite der Halbleiterschicht ein oberflächennaher p-n-Übergang vorhanden ist.

14) Verfahren nach einem der vorhergehenden Ansprüche, dadurch gekennzeichnet, daß auf einer Seite der Halbleiterschicht ein lichtdurchlässiger Schottky-Kontakt vorgesehen ist.

15) Verfahren nach einem der vorhergehenden Ansprüche, dadurch gekennzeichnet, daß auf einer Seite der Halbleiterschicht ein lichtdurchlässiger Hetero-Übergang vorgesehen ist.

16) Verfahren nach einem der vorhergehenden Ansprüche, dadurch gekennzeichnet, daß die Halbleiterschicht mit einer dünnen Isolatorschicht überzogen wird, und daß die Dicke dieser Isolatorschicht kleiner als $1 \cdot 10^{-6}$ cm ist.

17) Verfahren nach einem der vorhergehenden Ansprüche, dadurch gekennzeichnet, daß die Dicke der Isolatorschicht $2 \cdot 10^{-7}$ cm beträgt.

18) Verfahren nach einem der vorhergehenden Ansprüche, dadurch gekennzeichnet, daß das Halbleitermaterial in einer Atmosphäre aufgebracht wird, welche mit dem Halbleitermaterial nicht oder nur wenig, mit den Verunreinigungen im Halbleitermaterial jedoch stark reagiert.

19) Verfahren nach einem der vorhergehenden Ansprüche, dadurch gekennzeichnet, daß der Träger sich beim Aufbringen der Halbleiterschicht auf erhöhter Temperatur befindet.

20) Verfahren nach einem der vorhergehenen Ansprüche, dadurch gekennzeichnet, daß die Halbleiterschicht mit Hilfe einer Maske strukturiert auf den Träger aufgebracht wird.

21) Verfahren nach einem der vorhergehenden Ansprüche, dadurch gekennzeichnet, daß die Halbleiterschicht mit Hilfe eines Lichtbogen-Strahles oder eines Plasma-Strahles kurzzeitig aufgeheizt oder aufgeschmolzen wird.

0063716



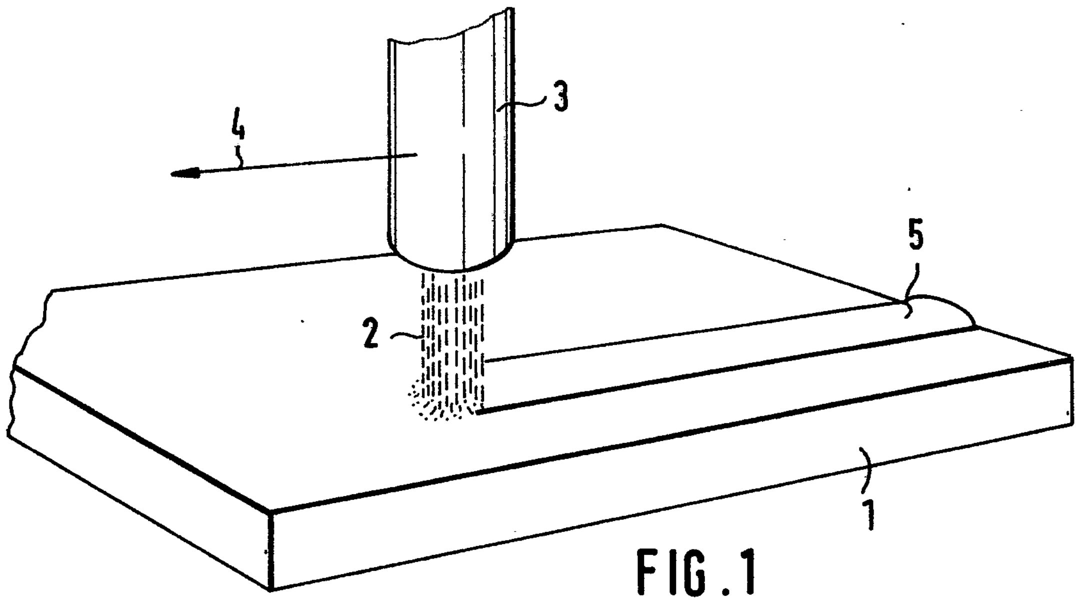


FIG.1

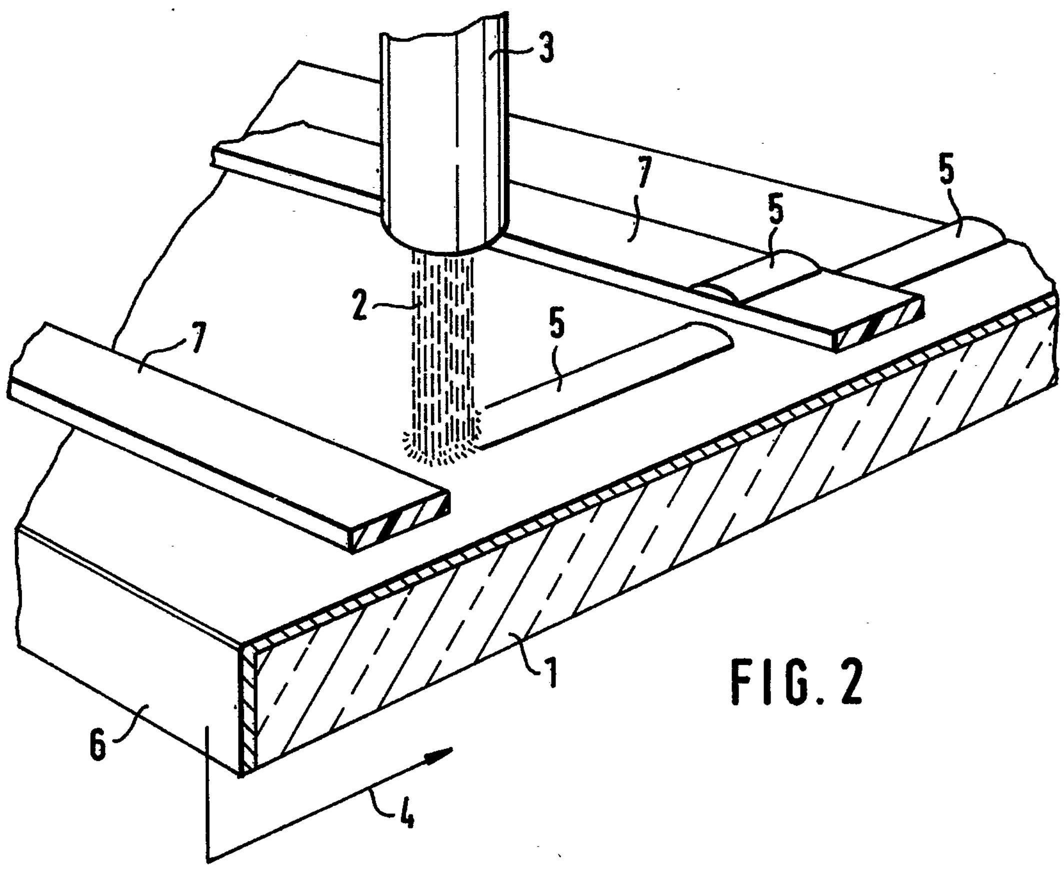


FIG.2

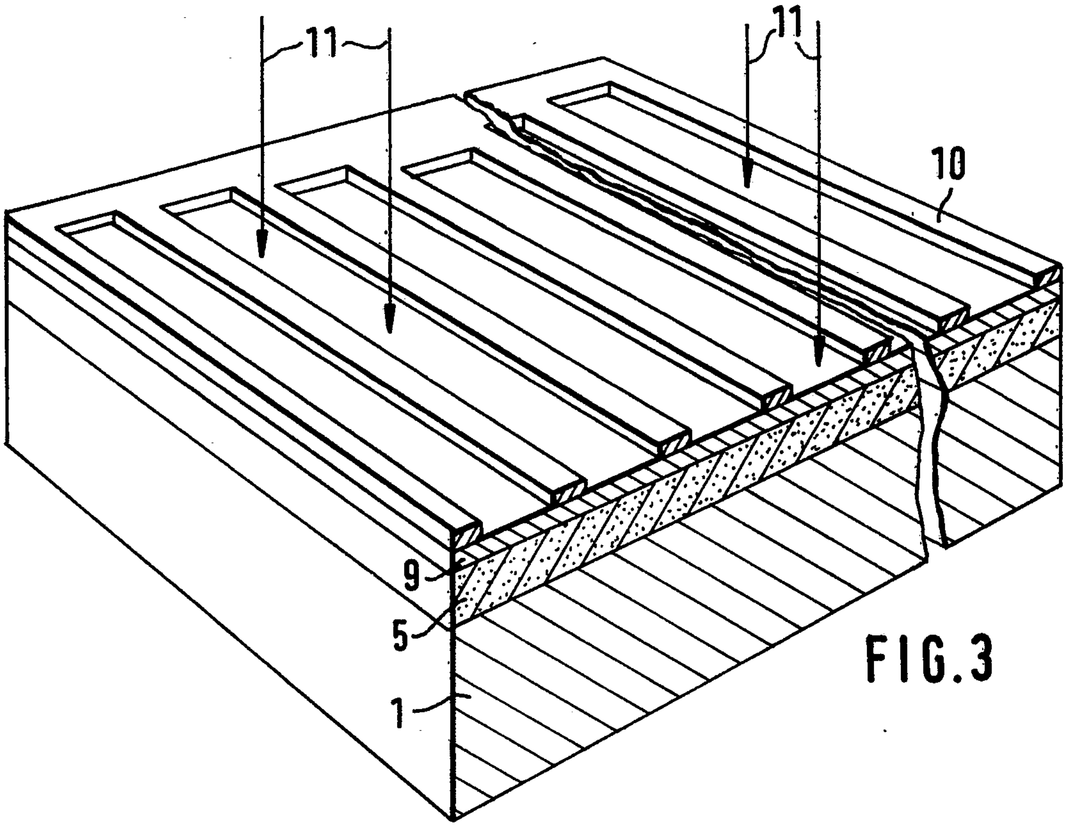


FIG.3

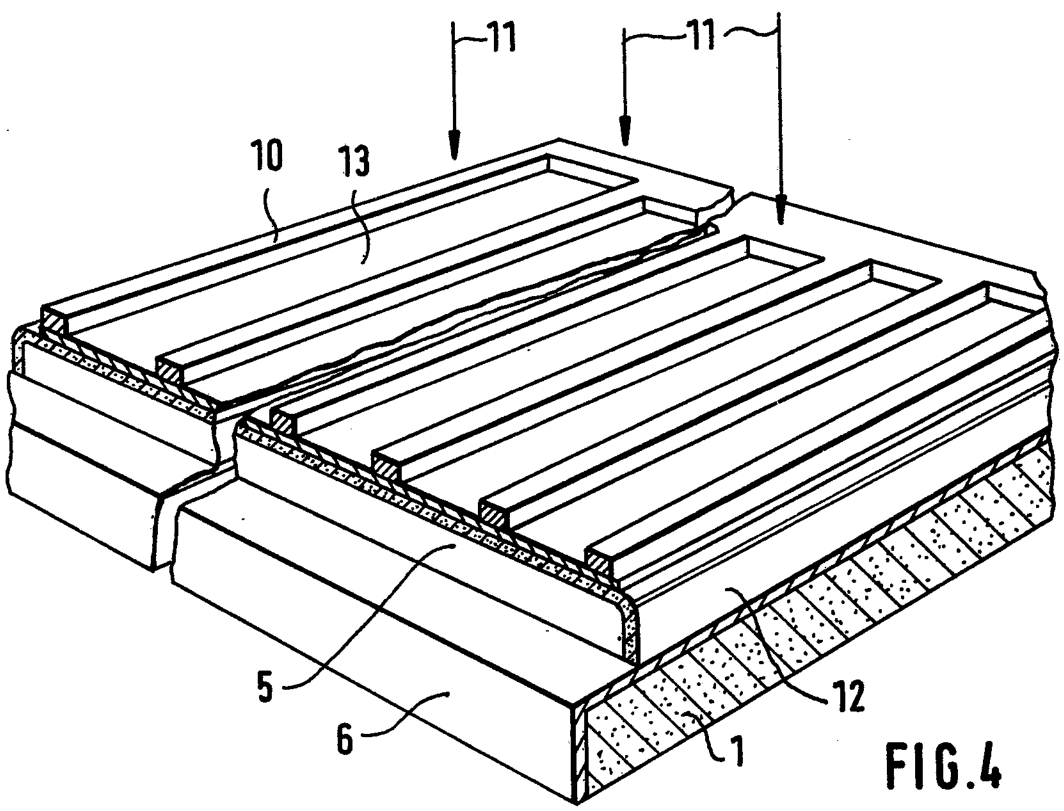


FIG.4

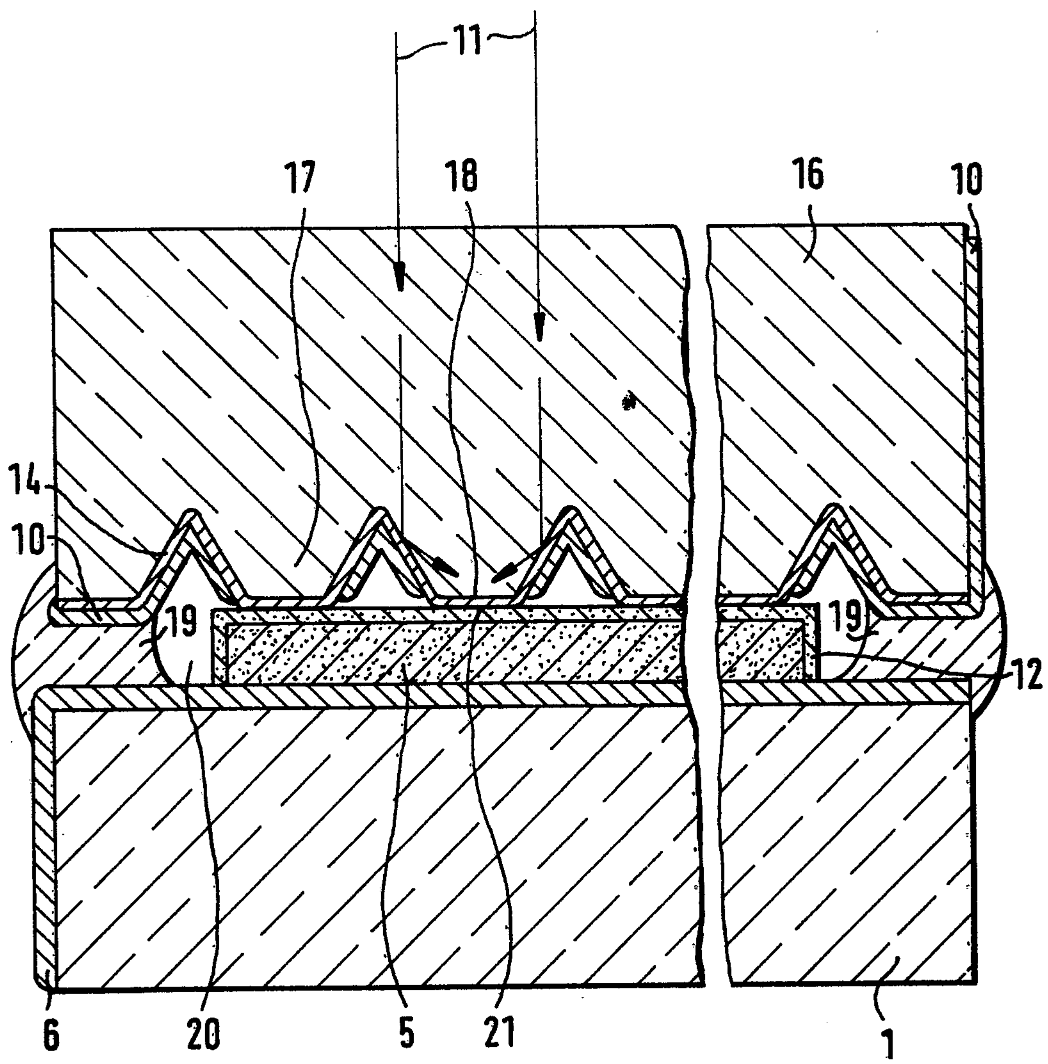


FIG.5